(19) **Europäisches Patentamt**

**European Patent Office**

**Office européen des brevets**

(11) **EP 1 487 113 B1**

(12) **EUROPÄISCHE PATENTSCHRIFT**

(45) Veröffentlichungstag und Bekanntmachung des Hinweises auf die Patenterteilung:
**18.10.2006 Patentblatt 2006/42**

(51) Int Cl.:
*H04N 7/50* (2006.01)    *G06T 9/00* (2006.01)
*H03M 7/40* (2006.01)    *H04N 7/32* (2006.01)
*H04N 7/30* (2006.01)

(21) Anmeldenummer: **04020471.1**

(22) Anmeldetag: **02.05.2003**

(54) **Kodierung und Dekodierung von Transformationskoeffizienten in Bild- oder Videokodierern**

Coding and decoding of transformation coefficients in image or video coders

Codage et décodage de coefficients de transformation dans des codeurs d'images ou de vidéo

(84) Benannte Vertragsstaaten:
**AT BE BG CH CY CZ DE DK EE ES FI FR GB GR HU IE IT LI LU MC NL PT RO SE SI SK TR**

(30) Priorität: **02.05.2002 DE 10220961**

(43) Veröffentlichungstag der Anmeldung:
**15.12.2004 Patentblatt 2004/51**

(62) Dokumentnummer(n) der früheren Anmeldung(en) nach Art. 76 EPÜ:
**03725142.8 / 1 500 281**

(73) Patentinhaber: **Fraunhofer-Gesellschaft zur Förderung der angewandten Forschung e.V.**
**80686 München (DE)**

(72) Erfinder:
• **Schwarz, Heiko**
**13187 Berlin (DE)**
• **Marpe, Detlef**
**12161 Berlin (DE)**
• **Wiegand, Thomas**
**10789 Berlin (DE)**

(74) Vertreter: **Schenk, Markus et al**
**Patentanwälte Schoppe, Zimmermann Stöckeler & Zinkler**
**Postfach 246**
**82043 Pullach (DE)**

(56) Entgegenhaltungen:
• **BJONTEGAARD G: "IMPROVED LOW COMPLEXITY ENTROPY CODING FOR TRANSFORM COEFFICIENTS" JOINT VIDEO TEAM (JVT) OF ISO/IEC MPEG & ITU-T VCEG (ISO/IEC JTC1/SC29/WG11 AND ITU-T SG16 Q.6), GENEVA, CH, 29. Januar 2002 (2002-01-29), Seiten 1-8, XP002257294**
• **MARPE D ET AL: "Video compression using context-based adaptive arithmetic coding" PROCEEDINGS 2001 INTERNATIONAL CONFERENCE ON IMAGE PROCESSING. ICIP 2001. THESSALONIKI, GREECE, OCT. 7 - 10, 2001, INTERNATIONAL CONFERENCE ON IMAGE PROCESSING, NEW YORK, NY : IEEE, US, Bd. VOL. 1 OF 3. CONF. 8, 7. Oktober 2001 (2001-10-07), Seiten 558-561, XP010563407 ISBN: 0-7803-6725-1**
• **BELL T ET AL: "Compression of sparse matrices by arithmetic coding" DATA COMPRESSION CONFERENCE, 1998. DCC '98. PROCEEDINGS SNOWBIRD, UT, USA 30 MARCH-1 APRIL 1998, LOS ALAMITOS, CA, USA, IEEE PRESS, 30. März 1998 (1998-03-30), Seiten 23-32, XP010276609 ISBN: 0-8186-8406-2**
• **TEUHOLA J: "A COMPRESSION METHOD FOR CLUSTERED BIT-VECTORS" INFORMATION PROCESSING LETTERS, AMSTERDAM, NL, Bd. 7, Nr. 6, Oktober 1978 (1978-10), Seiten 308-311, XP001000934 ISSN: 0020-0190**

**Beschreibung**

Die vorliegende Erfindung beschreibt ein Verfahren und eine Anordnung zur Kodierung von Transformations-Koeffizienten in Bild- und/oder Videokodierern und -dekodierern sowie ein entsprechendes Computerprogramm und ein entsprechendes computerlesbares Speichermedium, welche insbesondere als ein neues effizientes Verfahren zur binären arithmetischen Kodierung von Transformations-Koeffizienten im Bereich der Videokodierung (CABAC in H. 264/AVC, vgl. [1]) eingesetzt werden können.

In den gegenwärtigen hybriden block-basierten Standards zur Videokodierung wie beispielsweise MPEG-2 [2], H.263 [3] und MPEG-4 [4] werden die Blöcke von quantisierten Transformations-Koeffizienten (Levels) durch einen definierten Scan-Vorgang auf einen Vektor abgebildet, welcher durch die Verwendung einer Lauflängen-Kodierung und einer anschließenden Abbildung auf Kodeworte variabler Länge kodiert wird.

In MPEG-2 [2] werden die Kodeworte variabler Länge 2-dimensionalen Ereignissen (RUN, LEVEL) zugewiesen, wobei LEVEL den quantisierten Wert eines nicht zu Null quantisierten (signifikanten) Transformations-Koeffizientenrepräsentiert; die Lauflänge RUN gibt die Anzahl der aufeinander folgenden, zu Null quantisierten (nichtsignifikanten) Transformations-Koeffizienten an, welche in dem Vektor von Transformations-Koeffizienten unmittelbar vor dem gegenwärtigen signifikanten Transformations-Koeffizienten liegen. Zusätzlich werden Kodeworte variabler Länge für die zwei spezielle Ereignisse EOB und ESCAPE definiert. Während, das EOB-Ereignis angibt, dass keine weiteren signifikanten Transformations-Koeffizienten in dem Block vorhanden sind, signalisiert das ESCAPE-Ereignis, dass das vorhandene Ereignis (RUN, LEVEL) nicht durch das definierte Alphabet von Kodeworten variabler Länge repräsentiert werden kann. In diesem Fall, werden die Symbole RUN und LEVEL durch Kodeworte fester Länge kodiert.

In den neueren Kodier-Standards H.263 [3] und MPEG-4 [4] erfolgt die Zuordnung von Kodeworten variabler Länge auf der Basis von 3-dimensionalen Ereignissen (LAST, RUN, LEVEL), wobei das binäre Symbol LAST angibt, ob der gegenwärtige signifikante Transformations-Koeffizient der letzte signifikante Koeffizient innerhalb des Blockes ist oder ob noch weitere signifikante Transformations-Koeffizienten folgen. Durch die Verwendung dieser 3-dimenionalen Ereignisse wird kein zusätzliches EOB-Ereignis benötigt; ein ESCAPE-Ereignis wird analog zu MPEG-2 verwendet, wobei zusätzlich zu RUN und LEVEL noch das binäre Symbol LAST kodiert wird.

Die in MPEG-2, H.263 und MPEG-4 realisierte Kodierung der Transformations-Koeffizienten weist folgende Nachteile auf:

- Jedem Kodier-Ereignis kann nur ein Kodewort ganzzahliger Länge zugeordnet werden, eine effiziente Codierung von Ereignissen mit Wahrscheinlichkeiten größer 0.5 ist nicht gegeben.
- Die Verwendung einer festen Tabelle für die Abbildung der Kodier-Ereignisse auf die Kodeworte variabler Länge für alle Transformations-Koeffizienten innerhalb eines Blockes berücksichtigt nicht die positions- bzw. frequenzabhängigen Symbol-Statistiken.
- Es ist keine Adaption an die tatsächlich vorhandenen Symbol-Statistiken möglich.
- Es erfolgt keine Ausnutzung der vorhandenen Inter-Symbol-Redundanzen.

Der Annex E des H.263-Standards spezifiziert eine optionale, nicht-adaptive arithmetische Kodierung, bei welcher verschiedene, fest vorgegebene Modell-Wahrscheinlichkeitsverteilungen verwendet werden,

- eine jeweils für das erste, zweite und dritte Ereignis (LAST,RUN,LEVEL)/ESCAPE
- eine weitere für alle folgenden Ereignisse (LAST,RUN,LEVEL)/ESCAPE eines Blocks von Transformations-Koeffizienten,
- sowie jeweils eine weitere für die Symbole LAST, RUN und LEVEL, welche nach einem ESCAPE-Ereignis kodiert werden.

Durch diese optionale arithmetische Kodierung ist jedoch aus folgenden Gründen keine nennenswerte Steigerung der Kodier-Effizienz möglich:

- Der Vorteil der arithmetischen Kodierung, dass einem Kodier-Ereignis ein Kodewort nicht-ganzzahliger Länge zugewiesen werden kann, hat durch die Verwendung kombinierter Ereignisse der Form (LAST, RUN, LEVEL) kaum Auswirkungen auf die Kodier-Effizienz.
- Der Vorteil der Verwendung verschiedener Wahrscheinlichkeits-Verteilungen wird dadurch aufgehoben, dass keine Adaption an die tatsächlich vorhandenen Symbol-Statistiken möglich ist.

Eine der ersten veröffentlichten Verfahren zur Kodierung von Transformations-Koeffizienten durch eine adaptive binäre arithmetische Kodierung in einem hybriden Videokodierer, welches die Adaption der Wahrscheinlichkeiten an die vorhandenen Symbol-Statistiken gewährleistet, wurde in [5] vorgestellt.

In H.264/AVC [1] wird als Standard-Methode zur Entropie-Kodierung ein kontext-adaptives Verfahren auf der Basis von Kodeworten variabler Länge für die Codierung von Transformations-Koeffizienten spezifiziert. Hierbei wird die Codierung eines Blockes von Transformations-Koeffizienten durch folgende Merkmale bestimmt:

- Durch ein Symbol COEFF_TOKEN wird sowohl die Anzahl der signifikanten Koeffizienten innerhalb eines Blocks als auch die Anzahl der aufeinander folgenden zu Eins quantisierten Koeffizienten am Ende des Vektors von Transformations-Koeffizienten bestimmt. In Abhängigkeit vom Block-Typ sowie von bereits kodierten/dekodierten Symbolen COEFF_TOKEN für benachbarte Blöcke wird für die Kodierung eine von fünf definierten Kodewort-Tabellen ausgewählt.

- Während für die zu Eins quantisierten Transformations-Koeffizienten am Ende des Koeffizienten-Vektors nur ein einzelnes Bit zur Spezifikation des Vorzeichens übertragen wird, erfolgt die Kodierung der Werte (Levels) der restlichen signifikanten Transformations-Koeffizienten in umgekehrter Scan-Reihenfolge mittels eines kombinierten Prefix-Suffix-Kodewortes.

- Ist die Anzahl der signifikanten Transformations-Koeffizienten kleiner als die Anzahl der Transformations-Koeffizienten für den entsprechenden Block, wird ein Symbol TOTAL_ZEROS kodiert, welches die Anzahl der zu Null quantisierten Transformations-Koeffizienten, die im Koeffizienten-Vektor vor dem letzten signifikanten Koeffizienten liegen, angibt. Hierfür wurden achtzehn Kodewort-Tabellen spezifiziert, die in Abhängigkeit von der Anzahl der signifikanten Koeffizienten und des Block-Typs geschaltet werden.

- Die Lauflänge der zu Null quantisierten (nicht-signifikanten) Koeffizienten (RUN) vor einem signifikanten Koeffizienten wird für jeden signifikanten Transformations-Koeffizienten in umgekehrter Scan-Reihenfolge kodiert, solange die Summe der bereits kodierten RUN's kleiner ist als TOTAL_ZEROS. In Abhängigkeit von TOTAL_ZEROS und der bereits kodierten/dekodierten RUN's wird hierbei zwischen sieben Kodewort-Tabellen geschaltet.

Obwohl dieses sogenannte CAVLC-Verfahren (CAVLC: Context-Adaptive Variable Length Coding) durch die kontext-basierte Schaltung der Kodewort-Tabellen eine deutlich effizientere Kodierung der Transformations-Koeffizienten erlaubt als die in MPEG-2, H.263 und MPEG-4 spezifizierten Methoden, weist es im wesentlichen die folgenden Nachteile auf:

- Es wird zwar eine Schaltung zwischen verschiedenen Kodewort-Tabellen in Abhängigkeit von bereits kodierten/ dekodierten Symbolen vorgenommen, die Kodewort-Tabellen können jedoch nicht an die tatsächlichen Symbol-Statistiken angepasst werden.

- Durch die Verwendung von Kodeworten variabler Länge lassen sich Ereignisse mit Symbol-Wahrscheinlichkeiten größer 0.5 nicht effizient kodieren. Diese Beschränkung verhindert insbesondere die Kodierung von Symbolen mit einem kleineren Wertebereich, wodurch unter Umständen eine Konstruktion geeigneterer Kontexte für die Schaltung zwischen verschiedenen Modell-Wahrscheinlichkeitsverteilungen möglich wäre.

Eine mögliche Lösung zur Vermeidung der dargestellten Nachteile der bekannten Verfahren zur Kodierung von Transformations-Koeffizienten in block-basierten Bild- und Videokodierern stellt eine Kombination aus einer adaptiven arithmetischen Kodierung und einer geeigneten Kontext-Bildung zur Ausnutzung der Inter-Symbol-Redundanzen dar. Da der erhöhte Rechenaufwand der arithmetischen Kodierung im Vergleich zur Kodierung mittels Kodeworten variabler Länge einen Nachteil darstellt, ist hierbei insbesondere auf die Möglichkeit eine effizienten Hardware- und Software-Implementierung Rücksicht zu nehmen.

In Bjontegaard G: "Improved Low Complexity Entropy Coding for Transform Coefficients", JVTZ of ISO/IEC MPEG & ITU_T VCEG, genf, Schweiz, 29. Januar 2002, S. 1-8, wird eine Codierung von Luma-Koeffizienten beschrieben, die eine Lauflängencodierung verwendet. Insbesondere werden Paare von (Länge, Pegel) in umgekehrter Reihenfolge codiert - beginnend mit dem letzten Koeffizienten.

In Bell, T. et al.: "Compression of sparse matrices by arithmetic coding", Data Compression Conference, 1998, DCC '98, Proceedings Snowbird, UT, USA, 1998, S. 23 - 32 wird die Codierung von Positionen von Einträgen ungleich 0 in einer dünn besetzten Matrix beschrieben.

Die Aufgabe der Erfindung besteht somit darin, ein Verfahren und eine Anordnung zur Kodierung von Transformations-Koeffizienten in Bild- und/oder Videokodierern und -dekodierern sowie ein entsprechendes Computerprogramm und ein entsprechendes computerlesbares Speichermedium bereitzustellen, welche die oben genannten Mängel beheben und insbesondere den zur Kodierung erforderlichen Rechenaufwand gering halten.

Diese Aufgabe wird erfindungsgemäß durch die in Ansprüchen 1, 14 definierten Verfahren, durch die in Ansprüchen 10,15 definierten Anordnungen, durch das in Anspruch 11 definierte Computerprogramm, durch das in Anspruch 12 definierte computerlesbare Speichermedium sowie durch den in Anspruch 13 definierten Datenstrom gelöst. Zweckmäßige Ausgestaltungen der Erfindung sind in den Unteransprüchen enthalten.

Die Erfindung wird nachfolgend unter Bezugnahme auf die Figuren der Zeichnungen an einem Ausführungsbeispiel näher erläutert. Es zeigen:

Fig. 1    Veranschaulichung des Grundprinzips der Kodierung von Transformations-Koeffizienten gemäß dem erfindungsgemäßen Kodierungsverfahren,

Fig. 2    zwei Beispiele für die Kodierung der Signifikanz-Abbildung (die gelb markierten Symbole werden nicht übertragen),

Fig. 3    Binarisierung für die Beträge der Transformations-Koeffizienten (ABS),

Fig. 4    Block-Typen und deren Klassifikation für den H.264/AVC-Standard,

Fig. 5    Kontext-Modellierung für das Ein-Bit-Symbol CBP4 und

Fig. 6    Beispiele der Kontext-Modellierung für die Kodierung der Beträge der signifikanten Transformations-Koeffizienten.

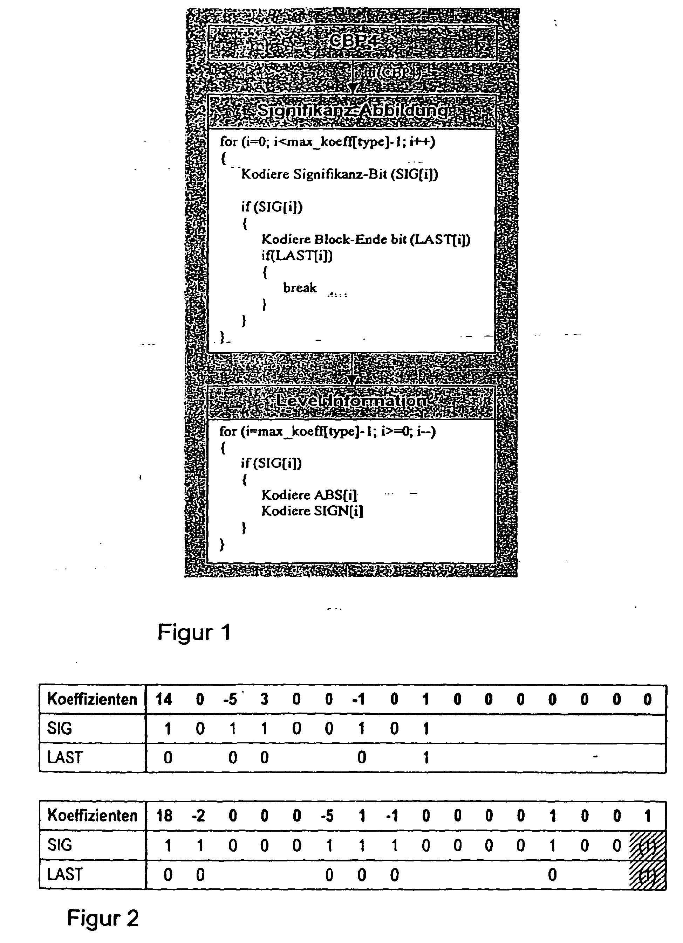

Figur 1 veranschaulicht das neue Kodierungsverfahren. Für jeden Block von Transformations-Koeffizienten wird zuerst ein Ein-Bit-Symbol CBP4 übertragen, es sei denn, höhergeordnete Syntax-Elemente (CBP oder Makroblock-Mode) zeigen bereits an, dass der betrachtete Block keine signifikanten Transformations-Koeffizienten enthält. Das CBP4-Symbol ist Null, wenn keine signifikanten Koeffizienten in dem Block vorhanden sind. Ist es Eins, wird eine Signifikanz-Abbildung kodiert, welche die Position (in Scan-Reihenfolge) der signifikanten Transformations-Koeffizienten spezifiziert. Anschließend werden die Beträge sowie die Vorzeichen der signifikanten Koeffizienten in umgekehrter Scan-Reihenfolge übertragen. Eine detaillierte Beschreibung des Kodierungsprozesses wird unten in Punkt 1 gegeben. Anschließend wird in Punkt 2 die Kontext-Modellierung für die binäre arithmetische Kodierung beschrieben.

## 1. Beschreibung der Kodierung der Transformations-Koeffizienten

### 1.1 Abtastung (Scan) der Tranformations-Koeffizienten

Die Transformations-Koeffizienten eines jeden Blocks werden mittels eines Scan-Vorgangs (zum Beispiel Zig-Zag-Scan) auf einen Vektor abgebildet.

### 1.2 Das CBP4-Symbol

CBP4 ist ein Ein-Bit-Symbol, welches angibt, ob signifikante Transformations-Koeffizienten (Transformations-Koeffizienten ungleich Null) in einem Block vorhanden sind. Ist das CBP4-Symbol Null, werden keine weiteren Informationen für den entsprechenden Block übertragen.

### 1.3 Die Signifikanz-Abbildung

Gibt das CBP4-Symbol an, dass der entsprechende Block signifikante Koeffizienten enthält, wird eine Signifikanz-Abbildung kodiert. Dies erfolgt durch die Übertragung eines Ein-Bit-Symbols (SIG) für jeden Koeffizienten in Scan-Reihenfolge. Ist ein entsprechendes Signifikanz Symbol Eins (signifikanter Koeffizient), wird ein weiteres Ein-Bit-Symbol (LAST) gesendet. Dieses Symbol gibt an, ob der gegenwärtige signifikante Koeffizient der letzte signifikante Koeffizient innerhalb des Blockes ist oder ob weitere signifikante Koeffizienten folgen. Die Figur 2 zeigt zwei Beispiele für die beschriebene Methode zur Kodierung der Signifikanz-Abbildung. Für die letzte Scan-Position eines Blockes wird niemals eine Signifikanz-Information (SIG, LAST) übertragen. Wurde die Übertragung der Signifikanz-Abbildung nicht bereits durch ein LAST-Symbol von Eins beendet, ist es offensichtlich, dass der Koeffizient an der letzten Scan-Position signifikant ist (siehe gelb markierte Position in Figur 2).

### 1.4 Die Level-Information

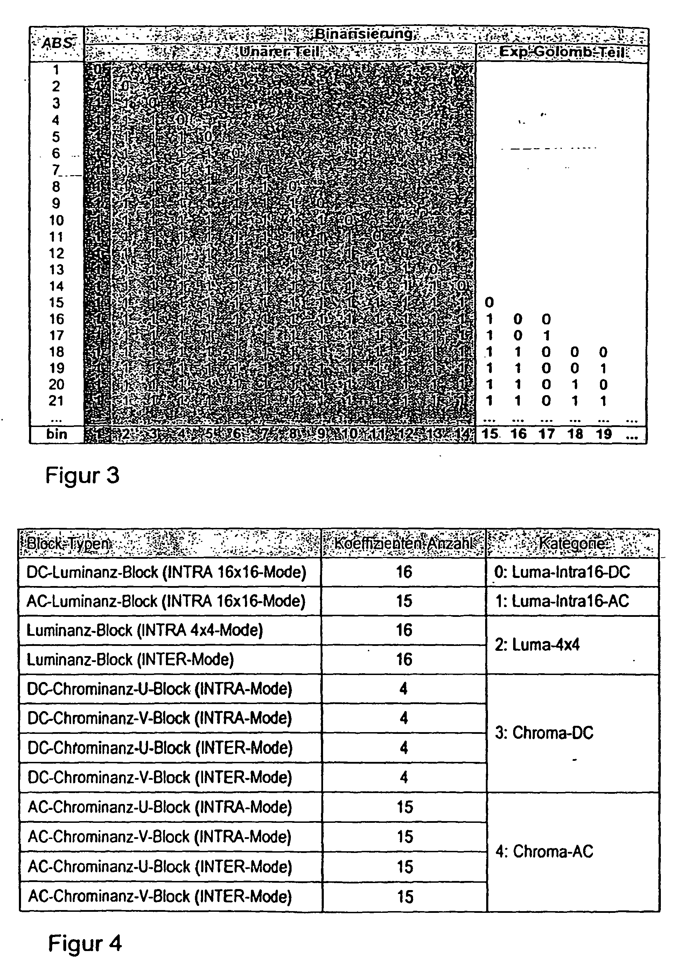

Durch die Signifikanz-Abbildung werden die Positionen der signifikanten Transformations-Koeffizienten innerhalb eines Blockes eindeutig spezifiziert. Die Kodierung der genauen Werte der Koeffizienten (Levels) erfolgt durch zwei Kodierungssymbole: ABS (Betrag der Koeffizienten) und SIGN (Vorzeichen der Koeffizienten). Während SIGN ein Ein-Bit-Symbol darstellt, wird zur Kodierung der Beträge der Koeffizienten (ABS) eine Binarisierung nach Figur 3 verwendet. Für Koeffizienten-Beträge im Intervall [1; 14] entspricht diese Binarisierung einer unären Binarisierung. Die Binarisierung für Koeffizienten-Beträge größer 14 setzt sich aus einem Präfix-Teil, der aus 14 Einsen besteht, und einem Suffix-Teil, der einen Exp-Golomb-Code 0-ter Ordnung für das Symbol (ABS-15) darstellt, zusammen. Die Binarisierung umfasst keine Repräsentation für Koeffizienten-Beträge (ABS) gleich 0, da signifikante Koeffizienten (Koeffizienten ungleich Null) stets einen Betrag (ABS) größer oder gleich Eins aufweisen.

Die aus einem Präfix-Teil und einem durch einen Exp-Golomb-Code 0-ter Ordnung bestehenden Suffix-Teil zusammengesetzten Binarisierung für Koeffizienten-Beträge größer 14 hat den Vorteil, dass ohne Einbußen an Kodier-Effizienz für alle binären Entscheidungen des Suffix-Teil ein spezieller nicht-adaptiver Kontext mit den Symbol-Wahrscheinlichkeiten 0.5 verwendet werden kann, wodurch sich der Rechenaufwand für die Enkodierung und die Dekodierung reduzieren lässt.

Die Levels werden in umgekehrter Scan-Reihenfolge - beginnend mit dem letzten signifikanten Koeffizienten innerhalb eines Blocks - kodiert; dies erlaubt die Bildung geeigneter Kontexte für die binäre arithmetische Kodierung.

## 2. Die Kontext-Modellierung

Im allgemeinen werden im Rahmen eines Bild- und/oder Videokodiersystems verschiedene Typen von Transformations-Koeffizienten-Blöcken unterschieden. So gibt es beispielsweise im gegenwärtigen Final Draft International Standard [1] des H.264/AVC-Standards 12 Typen von Transformations-Koeffizienten-Blöcken, die unterschiedliche Statistiken aufweisen (siehe linke Spalte der Tabelle in Figur 4). Für die meisten Bildsequenzen und Kodierbedingungen sind jedoch einige der Statistiken sehr ähnlich. Um die Anzahl der verwendeten Kontexte gering zu halten und somit eine schnelle Adaption an die Statistiken der zu kodierenden Bildsequenz zu gewährleisten, können beispielsweise die Block-Typen im H.264/AVC-Standard in 5 Kategorien eingeteilt werden (siehe rechte Spalte der Tabelle in Figur 4). Ähnliche Klassifikationen sind für andere Bild- und/oder Videokodiersysteme möglich. Für jede der - im Fall des H.264/AVC-Standards - fünf Kategorien wird eine eigene Menge von Kontexten für die Symbole CBP4, SIG, LAST, und ABS verwendet.

### 2.1 Kontext-Modellierung für das CBP4-Symbol

Für die Kodierung des Ein-Bit-Symbols CBP4 werden vier unterschiedliche Kontexte für jede einzelne Kategorie von Transformations-Blöcken (siehe Figur 4) verwendet. Die Kontext-Nummer für den zu kodierenden Block C wird durch

$$\text{ctx\_number\_cbp4 (C)} = \text{CBP4 (A)} + 2 \times \text{CBP4 (B)}$$

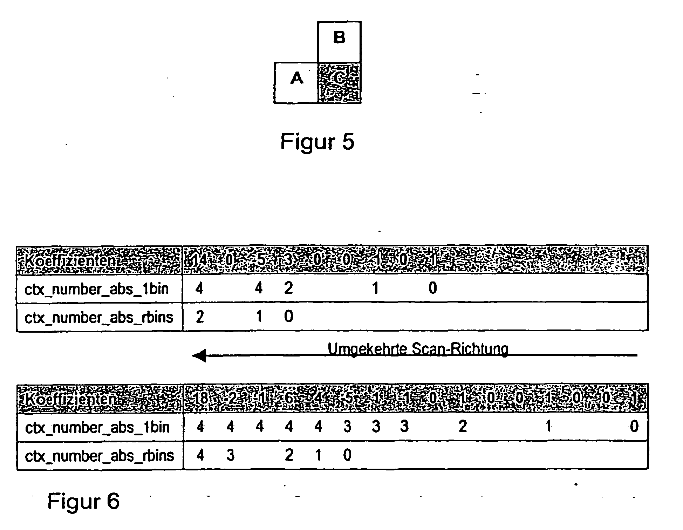

bestimmt, wobei durch A und B diejenigen benachbarten Blöcke (links und oben) des betrachteten Blockes C bezeichnet werden (siehe Abbildung 5), die dem gleichen Block-Typ zuzuordnen sind. Im Rahmen des H.264/AVC-Standards werden für diese Konditionierung folgende 6 Block-Typen unterschieden: Luma-DC, Luma-AC, Chroma-U-DC, Chroma-U-AC, Chroma-V-DC, und Chroma-V-AC. Existiert der betreffende Block X (A oder B) von Transformations-Koeffizienten in einem benachbarten Macroblock nicht (dies ist beispielsweise der Fall, wenn der gegenwärtige Block im INTRA16x16-Mode kodiert wird, der benachbarte Block jedoch im einem INTER-Mode übertragen wurde), wird CBP4 (X) für den benachbarten Block X auf Null gesetzt. Liegt ein benachbarter Block X (A oder B) außerhalb des Bildbereiches oder gehört er zu einer anderen Slice, wird der entsprechende Wert CBP4 (X) durch einen Default-Wert ersetzt. Für INTRA-kodierte Blöcke wird ein Default-Wert von Eins, für INTER-kodierte Blöcke eine Default-Wert von Null verwendet.

### 2.2 Kontext-Modellierung für die Kodierung der Signifikanz-Abbildung

Für die Kodierung der Signifikanz-Abbildung werden pro Block-Kategorie (siehe Figur 4) jeweils max_koeff-1 verschiedene Kontexte für die Kodierung der Symbole SIG und LAST verwendet. Durch max_koeff wird hierbei die Anzahl der Transformations-Koeffizienten für die entsprechende Block-Kategorie (für H.264/AVC, siehe Figur 4) bezeichnet. Die Kontext-Nummer ist stets durch die entsprechende Scan-Position des betrachteten Koeffizienten gegeben. Die Kontext-Nummern eines Koeffizienten koeff[i], der als i-ter Koeffizient gescannt wurde, ergeben sich somit zu

$$\text{ctx\_number\_sig(koeff[i])} = \text{ctx\_number\_last(koeff[i])} = i.$$

Es werden für jede Kategorie von Block-Typen 2xmax_koeff-2 Kontexte für die Kodierung der Signifikanz-Abbildung benutzt.

### 2.3 Kontext-Modellierung für die Kodierung der Koeffizienten-Beträge

Für die Kodierung der Beträge der signifikanten Transformations-Koeffizienten wird die in Figur 3 dargestellte Binarisierung verwendet. Hierbei kommen pro Block-Kategorie zwei unterschiedliche Kontext-Mengen zum Einsatz, eine für die Kodierung der ersten binären Entscheidung bin = 1 (in Figur 3 orange markiert), und eine weitere für die Kodierung der binären Entscheidungen bin = 2..14 (in Figur 3 grün markiert) der Binarisierung. Die Kontext-Nummern werden wie folgt zugewiesen:

```
ctx_number_abs_1bin
    = (koeff mit ABS>1 kodiert ? 4 :
        max(3, Anzahl der kodierten Koeffizienten mit ABS=1)),


ctx_number_abs_rbins
    = max(4, Anzahl der kodierten Koeffizienten mit ABS>1).
```

Die Beträge der Transformations-Koeffizienten werden im umgekehrter Scan-Reihenfolge übertragen. Der Kontext für die erste binären Entscheidung wird durch die Anzahl der bereits übertragenen Koeffizienten (in umgekehrter Scan-Reihenfolge) bestimmt, die einen Betrag von ABS=1 aufweisen. Wurden bereits mehr als 3 Koeffizienten mit dem Betrag ABS=1 übertragen, wird stets der Kontext mit der Nummer 3 gewählt. Sobald ein Koeffizient mit einem Betrag ABS>1 gesendet wurde, wird der Kontext 4 für alle restlichen signifikanten Koeffizienten innerhalb des Blockes verwendet.

Alle binären Entscheidungen mit bin = 2..14 werden unter Verwendung ein und desselben Kontexts kodiert. Hierbei wird die Kontext-Nummer durch die Anzahl der bereits kodierten Koeffizienten (in umgekehrter Scan-Reihenfolge) mit einem Betrag ABS>1 bestimmt, wobei eine Beschränkung auf die maximale Kontext-Nummer von 4 vorgenommen wird. Zur Veranschaulichung sind in der Figur 6 zwei Beispiele für die Kontext-Auswahl bei der Kodierung der Beträge ABS der signifikanten Transformations-Koeffizienten dargestellt.

Für die Kodierung der binären Entscheidungen bin>14 für die Koeffizienten-Beträge sowie für die Vorzeichen SIGN wird ein einzelner nicht-adaptiver Kontext mit den Symbol-Wahrscheinlichkeiten $P_0=P_1=0.5$ verwendet.

Die Erfindung beschränkt sich in ihrer Ausführungsform nicht auf die vorstehend angegebenen bevorzugten Ausführungsbeispiele. Vielmehr ist eine Anzahl von Varianten denkbar, die von der erfindungsgemäßen Anordnung und dem erfindungsgemäßen Verfahren auch bei grundsätzlich anders gearteten Ausführungen Gebrauch machen.

**Quellennachweis**

[1] T. Wiegand, G. Sullivan, "Draft Text of Final Draft International Standard (FDIS) of Joint Video Specification (ITU-T Rec. H.264 | ISO/IEC 14496-10 AVC)", JVT-G050, March 2003.

[2] ITU-T and ISO/IEC JTC1, "Generic coding of moving pictures and associated audio information - Part 2: Video", ITU-T Recommendation H.262 - ISO/IEC 13818-2 (MPEG-2), Nov. 1994.

[3] ITU-T, "Video coding for low bitrate communications", ITU-T Recommendation H.263; version 1, Nov. 1995; version 2, Jan. 1998.

[4] ISO/IEC JTC1, "Coding of audio-visual objects - Part 2: Visual", ISO/IEC 14496-2 (MPEG-4 visual version 1), Apr. 1999; Amendment 1 (version 2), Feb. 2000; Amendment 4 (streaming profile), Jan. 2001.

[5] C.A. Gonzales, "DCT coding of motion sequences including arithmetic coder", ISO-IEC/JTC1/SC2/WG8, MPEG 89/187, Aug. 1989.

**Patentansprüche**

1.  Verfahren zur Kodierung von Transformations-Koeffizienten in Bild- und/oder Videokodierern und -dekodierern **dadurch gekennzeichnet, dass**
    für Transformations-Koeffizienten ungleich Null enthaltende Blöcke von (Video-)Bildern eine Kodierung von Transformations-Koeffizienten derart erfolgt, dass für jeden Block

    - eine Signifikanz-Abbildung kodiert wird, welche die Positionen von Transformations-Koeffizienten ungleich Null in dem Block in Scan-Reihenfolge spezifiziert, und anschließend
    - in umgekehrter Scan-Reihenfolge - beginnend mit dem letzten Transformations-Koeffizienten ungleich Null innerhalb des Blocks - die Werte (Levels) der Transformations-Koeffizienten ungleich Null kodiert werden.

2. Verfahren nach Anspruch 1,
**dadurch gekennzeichnet, dass**
bei der Kodierung der Signifikanz-Abbildung jeder Transformations-Koeffizient ungleich Null in Scan-Reihenfolge mit einem ersten Ein-Bit-Symbol (SIG), das der Kennzeichnung von Transformationskoeffizienten ungleich Null dient, gekennzeichnet wird, und zwar jeder Transformations-Koeffizient ungleich Null bis einschließlich des letzten Transformations-Koeffizienten ungleich Null in Scan-Reihenfolge, falls dieser vom letzten Transformations-Koeffizienten des Blocks in Scan-Reihenfolge verschieden ist, oder bis ausschließlich des letzten Transformations-Koeffizient ungleich Null in Scan-Reihenfolge, falls dieser der letzte Transformations-Koeffizient des Blocks in Scan-Reihenfolge ist, und der letzte Transformations-Koeffizient ungleich Null mit einem zweiten Ein-Bit-Symbol (LAST), das angibt, dass der jeweilige Transformations-Koeffizient ungleich Null der letzte Transformations-Koeffizient ungleich Null in Scan-Reihenfolge ist, gekennzeichnet wird, falls dieser vom letzten Transformations-Koeffizienten des Blocks in Scan-Reihenfolge verschieden ist.

3. Verfahren nach einem der Ansprüche 1 oder 2,
**dadurch gekennzeichnet, dass**
für jeden Transformations-Koeffizienten ungleich Null das Vorzeichen durch ein Ein-Bit-Symbol (SIGN) und der Betrag durch ein binär kodiertes Symbol (ABS) angegeben wird.

4. Verfahren nach einem der vorangehenden Ansprüche,
**dadurch gekennzeichnet, dass**
der Betrag durch ein Symbol (ABS) in unärer Binarisierung oder durch ein einen Präfix-Teil und einen Suffix-Teil aufweisendes Symbol (ABS) angegeben wird, wobei der Präfix-Teil aus Einsen besteht und der Suffix-Teil in einem Exp-Golomb-Code 0-ter Ordnung kodiert ist.

5. Verfahren nach einem der vorangehenden Ansprüche,
**dadurch gekennzeichnet, dass**
Transformations-Koeffizienten ungleich Null enthaltende Blöcke durch ein Ein-Bit-Symbol (CBP4) im Zusammenhang mit weiteren Syntax-Elementen wie beispielsweise (CBP) oder Makroblock-Mode gekennzeichnet werden.

6. Verfahren nach einem der vorangehenden Ansprüche,
**dadurch gekennzeichnet, dass**
durch die Übertragung eines Ein-Bit-Symbols (SIG) für jeden Koeffizienten eines Blocks und eines Ein-Bit-Symbols (LAST) für jeden Transformations-Koeffizienten ungleich Null eines Blocks die Signifikanz-Abbildung kodiert wird, wobei die Übertragung in Scan-Reihenfolge erfolgt, (SIG) der Kennzeichnung von Transformations-Koeffizienten ungleich Null dient und (LAST) angibt, ob in dem Block weitere Transformations-Koeffizienten ungleich Null vorhanden sind.

7. Verfahren nach Anspruch 5,
**dadurch gekennzeichnet, dass**
die Modellierung

- für das Ein-Bit-Symbol (CBP4),
- für die Kodierung der Signifikanz-Abbildung und/oder
- für die Kodierung der Koeffizienten-Beträge kontextabhängig erfolgt.

8. Verfahren nach einem der vorangehenden Ansprüche 6 oder 7, **dadurch gekennzeichnet, dass**
für die letzte Scan-Position eines Blockes keine Signifikanz-Information (SIG, LAST) übertragen wird.

9. Verfahren nach einem der vorangehenden Ansprüche,
**dadurch gekennzeichnet, dass**
Block-Typen von Transformations-Koeffizienten mit vergleichbaren Statistiken zu Block-Kategorien zusammengefasst werden.

10. Anordnung mit mindestens einem Prozessor und/oder Chip, der (die) derart eingerichtet ist (sind), dass ein Verfahren zur Kodierung von Transformations-Koeffizienten in Bild- und/oder Videokodierern und -dekodierern durchführbar ist, wobei

für Transformations-Koeffizienten ungleich Null enthaltende Blöcke von (Video-)Bildern eine Kodierung von Transformations-Koeffizienten derart erfolgt, dass für jeden Block

    - eine Signifikanz-Abbildung kodiert wird, welche die Positionen von Transformations-Koeffizienten ungleich Null in dem Block in Scan-Reihenfolge spezifiziert, und anschließend
    - in umgekehrter Scan-Reihenfolge - beginnend mit dem letzten Transformations-Koeffizienten ungleich Null innerhalb des Blocks - die Werte (Levels) der Transformations-Koeffizienten ungleich Null kodiert werden.

**11.** Computerprogramm, das es einem Computer ermöglicht, nachdem es in den Speicher des Computers geladen worden ist, ein Verfahren zur Kodierung von Transformations-Koeffizienten in Bild- und/oder Videokodierern und -dekodierern durchzuführen, wobei
für Transformations-Koeffizienten ungleich Null enthaltende Blöcke von (Video-)Bildern eine Kodierung von Transformations-Koeffizienten derart erfolgt, dass für jeden Block

    - eine Signifikanz-Abbildung kodiert wird, welche die Positionen von Transformations-Koeffizienten ungleich Null in dem Block in Scan-Reihenfolge spezifiziert, und anschließend
    - in umgekehrter Scan-Reihenfolge - beginnend mit dem letzten Transformations-Koeffizienten ungleich Null innerhalb des Blocks - die Werte (Levels) der Transformations-Koeffizienten ungleich Null kodiert werden.

**12.** Computerlesbares Speichermedium, auf dem ein Programm gespeichert ist, das es einem Computer ermöglicht, nachdem es in den Speicher des Computers geladen worden ist, ein Verfahren zur Kodierung von Transformations-Koeffizienten in Bild- und/oder Videokodierern und -dekodierern durchzuführen, wobei
für Transformations-Koeffizienten ungleich Null enthaltende Blöcke von (Video-)Bildern eine Kodierung von Transformations-Koeffizienten derart erfolgt, dass für jeden Block

    - eine Signifikanz-Abbildung kodiert wird, welche die Positionen von Transformations-Koeffizienten ungleich Null in dem Block in Scan-Reihenfolge spezifiziert, und anschließend
    - in umgekehrter Scan-Reihenfolge - beginnend mit dem letzten Transformations-Koeffizienten ungleich Null innerhalb des Blocks - die Werte (Levels) der Transformations-Koeffizienten ungleich Null kodiert werden.

**13.** Datenstrom, der ein Computerprogramm repräsentiert, das es einem Computer ermöglicht, nachdem es in den Speicher des Computers geladen worden ist, ein Verfahren zur Kodierung von Transformations-Koeffizienten in Bild- und/oder Videokodierern und -dekodierern durchzuführen, wobei
für Transformations-Koeffizienten ungleich Null enthaltende Blöcke von (Video-)Bildern eine Kodierung von Transformations-Koeffizienten derart erfolgt, dass für jeden Block

    - eine Signifikanz-Abbildung kodiert wird, welche die Positionen von Transformations-Koeffizienten ungleich Null in dem Block in Scan-Reihenfolge spezifiziert, und anschließend
    - in umgekehrter Scan-Reihenfolge - beginnend mit dem letzten Transformations-Koeffizienten ungleich Null innerhalb des Blocks - die Werte (Levels) der Transformations-Koeffizienten ungleich Null kodiert werden.

**14.** Verfahren zur Dekodierung einer Kodierung einer Signifikanz-Abbildung und einer sich hieran anschließenden Kodierung von Werten von Transformations-Koeffizienten ungleich Null für Transformations-Koeffizienten ungleich Null enthaltende Blöcke von (Video-) Bildern, wobei die Signifikanz-Abbildung die Positionen der Transformations-Koeffizienten ungleich Null in Scan-Reihenfolge spezifiziert, und die Kodierung von Werten von Transformations-Koeffizienten ungleich Null kodierte Werte der Transformations-Koeffizienten ungleich Null in umgekehrter Scan-Reihenfolge - beginnend mit dem letzen Transformations-Koeffizienten ungleich Null - aufweist, mit folgendem Schritt:

    Dekodieren der Signifikanzabbildung; und
    Dekodieren der kodierten Werte von Transformations-Koeffizienten ungleich Null in umgekehrter Scan-Reihenfolge.

**15.** Vorrichtung zur Dekodierung einer Kodierung einer Signifikanz-Abbildung und einer sich hieran anschließenden Kodierung von Werten von Transformations-Koeffizienten ungleich Null für Transformations-Koeffizienten ungleich Null enthaltende Blöcke von (Video-) Bildern, wobei die Signifikanz-Abbildung die Positionen der Transformations-Koeffizienten ungleich Null in Scan-Reihenfolge spezifiziert, und die Kodierung von Werten von Transformations-Koeffizienten ungleich Null kodierte Werte der Transformations-Koeffizienten ungleich Null in umgekehrter Scan-Reihenfolge - beginnend mit dem letzten Transformations-Koeffizienten ungleich Null - aufweist, mit folgender Einrichtung

einer Einrichtung zum Dekodieren der Signifikanzabbildung; und

einer Einrichtung zum Dekodieren der kodierten Werte von Transformations-Koeffizienten ungleich Null in umgekehrter Scan-Reihenfolge.

**Claims**

1.  A method for coding transform coefficients in picture and/or video coders and decoders **characterized in that** for blocks of (video) pictures containing transform coefficients being unequal to zero, a coding of transform coefficients takes place in such a way that, for each block,

    - a significance mapping is coded specifying the positions of transform coefficients being unequal to zero in the block in a scan order, and subsequently,
    - in a reverse scan order - starting with the last transform coefficient being unequal to zero within the block - the values (levels) of the transform coefficients being unequal to zero are coded.

2.  The method according to claim 1, **characterized in that** when coding the significance mapping, each transform coefficient being unequal to zero in the scan order is **characterized by** a first one-bit symbol (SIG) serving to characterize transform coefficients being unequal to zero, i. e. each transform coefficient being unequal to zero including the last transform coefficient being unequal to zero in the scan order if it is different from the last transform coefficient of the block in the scan order, or excluding the last transform coefficient being unequal to zero in the scan order if it is the last transform coefficient of the block in the scan order, and the last transform coefficient being unequal to zero is **characterized by** a second one-bit symbol (LAST) indicating that the respective transform coefficient being unequal to zero is the last transform coefficient being unequal to zero in the scan order if it is different from the last transform coefficient of the block in the scan order.

3.  The method according to claim 1 or 2, **characterized in that** for each transform coefficient being unequal to zero, the sign is indicated by a one-bit symbol (SIGN) and the magnitude is indicated by a binary-coded symbol (ABS).

4.  The method according to one of the preceding claims, **characterized in that** the magnitude is indicated by a symbol (ABS) in unary binarization or by a symbol (ABS) having a prefix part and a suffix part, wherein the prefix part consists of ones and the suffix part is coded in a 0th order exp-golomb code.

5.  The method according to one of the preceding claims, **characterized in that** blocks containing transform coefficients being unequal to zero are **characterized by** a one-bit symbol (CBP4) in connection with further syntax elements, such as, for example, (CBP) or macro block mode.

6.  The method according to one of the preceding claims, **characterized in that** by transferring a one-bit symbol (SIG) for each coefficient of a block and a one-bit symbol (LAST) for each transform coefficient being unequal to zero of a block, the significance mapping is coded, wherein the transfer takes place in a scan order, (SIG) serves for identifying transform coefficients being unequal to zero and (LAST) indicates whether there are further transform coefficients being unequal to zero in the block.

7.  The method according to claim 5, **characterized in that** modeling

    - for the one-bit symbol (CBP4),
    - for coding the significance mapping and/or

- for coding the coefficient magnitudes

takes place in a context-dependent way.

**8.** The method according to claim 6 or 7,
**characterized in that**
no significance information (SIG, LAST) is transferred for the last scan position of a block.

**9.** The method according to one of the preceding claims,
**characterized in that**
block types of transform coefficients having comparable statistics are summarized to block categories.

**10.** An arrangement having at least one processor and/or chip formed such that a method for coding transform coefficients in picture and/or video coders and decoders can be performed, wherein
for blocks of (video) pictures containing transform coefficients being unequal to zero, a coding of transform coefficients takes place in such a way that, for each block,

- a significance mapping is coded specifying the positions of transform coefficients being unequal to zero in the block in a scan order, and subsequently,
- in a reverse scan order - starting with the last transform coefficient being unequal to zero within the block - the values (levels) of the transform coefficients being unequal to zero are coded.

**11.** A computer program enabling a computer, after having been loaded into the memory of the computer, to perform a method for coding transform coefficients in picture and/or video coders and decoders, wherein
for blocks of (video) pictures containing transform coefficients being unequal to zero, a coding of transform coefficients takes place in such a way that, for each block,

- a significance mapping is coded specifying the positions of transform coefficients being unequal to zero in the block in a scan order, and subsequently,
- in a reverse scan order starting with the last transform coefficient being unequal to zero within the block - the values (levels) of the transform coefficients being unequal to zero are coded.

**12.** A computer-readable storage medium on which a program is stored, enabling a computer, after having been loaded into the memory of the computer, to perform a method for coding transform coefficients in picture and/or video coders and decoders, wherein
for blocks of (video) pictures containing transform coefficients being unequal to zero, a coding of transform coefficients takes place in such a way that, for each block,

- a significance mapping is coded specifying the positions of transform coefficients being unequal to zero in the block in a scan order, and subsequently,
- in a reverse scan order - starting with the last transform coefficient being unequal to zero within the block - the values (levels) of the transform coefficients being unequal to zero are coded.

**13.** A data stream representing a computer program enabling a computer, after having been loaded into the memory of the computer, to perform a method for coding transform coefficients in picture and/or video coders and decoders, wherein
for blocks of (video) pictures containing transform coefficients being unequal to zero, a coding of transform coefficients takes place in such a way that, for each block,

- a significance mapping is coded specifying the positions of transform coefficients being unequal to zero in the block in a scan order, and subsequently,
- in a reverse scan order - starting with the last transform coefficient being unequal to zero within the block - the values (levels) of the transform coefficients being unequal to zero are coded.

**14.** A method for decoding a coding of a significance mapping and a subsequent coding of values of transform coefficients being unequal to zero for blocks of (video) pictures containing transform coefficients being unequal to zero, wherein the significance mapping specifies the positions of the transform coefficients being unequal to zero in a scan order, and the coding of values of transform coefficients being unequal to zero comprises coded values of the transform coefficients being unequal to zero in a reverse scan order - starting from the last transform coefficient being unequal to zero, comprising the steps of:

decoding the significance mapping; and
decoding the coded values of transform coefficients being unequal to zero in reverse scan order.

**15.** A device for decoding a coding of a significance mapping and a subsequent coding of values of transform coefficients being unequal to zero for blocks of (video) pictures containing transform coefficients being unequal to zero, wherein the significance mapping specifies the positions of the transform coefficients being unequal to zero in a scan order, and the coding of values of transform coefficients being unequal to zero comprises coded values of the transform coefficients being unequal to zero in a reverse scan order - starting from the last transform coefficient being unequal to zero, comprising:

means for decoding the significance mapping; and
means for decoding the coded values of transform coefficients being unequal to zero in reverse scan order.

## Revendications

**1.** Procédé pour le codage de coefficients de transformation dans des codeurs et décodeurs d'image et/ou vidéo, **caractérisé par le fait que**
pour les blocs d'images (vidéo) contenant des coefficients de transformation différents de zéro a lieu un codage des coefficients de transformation de sorte que pour chaque bloc

- soit codée une reproduction de signification qui spécifie les positions des coefficients de transformation différents de zéro dans le bloc dans l'ordre de balayage, et ensuite
- dans l'ordre de balayage inverse, en commençant par le dernier coefficient de transformation différent de zéro dans le bloc, soient codées les valeurs (levels) des coefficients de transformation différents de zéro.

**2.** Procédé selon la revendication 1, **caractérisé par le fait que**
lors du codage de la reproduction de signification, chaque coefficient de transformation différent de zéro est caractérisé, dans l'ordre de balayage, par un premier symbole d'un seul bit (SIG) qui sert à la caractérisation des coefficients de transformation différents de zéro, et que chaque coefficient de transformation différent de zéro, jusqu'à y compris le dernier coefficient de transformation différent de zéro, s'il est différent du dernier coefficient de transformation du bloc dans l'ordre de balayage, ou jusqu'au dernier coefficient de transformation différent de zéro dans l'ordre de balayage exclus, s'il est le dernier coefficient de transformation du bloc dans l'ordre de balayage, est **caractérisé par** un deuxième symbole d'un seul bit (LAST) qui indique que le coefficient de transformation différent de zéro respectif est le dernier coefficient de transformation différent de zéro dans l'ordre de balayage s'il est différent du dernier coefficient de transformation du bloc dans l'ordre de balayage.

**3.** Procédé selon l'une des revendications 1 ou 2, **caractérisé par le fait que**
pour chaque coefficient de transformation différent de zéro, le signe est indiqué par un symbole d'un seul bit (SIGN) et la quantité est indiquée par un symbole codé de manière binaire (ABS).

**4.** Procédé selon l'une des revendications précédentes, **caractérisé par le fait que**
la quantité est indiquée par un symbole (ABS) en binarisation unaire ou par un symbole (ABS) présentant un élément de préfixe et un élément de suffixe, l'élément de préfixe étant composé de uns et l'élément de suffixe étant codé pour obtenir un code Exp-Golomb de l'ordre 0.

**5.** Procédé selon l'une des revendications précédentes, **caractérisé par le fait que**
les blocs contenant des coefficients de transformation différents de zéro sont **caractérisés par** un symbole d'un seul bit (CBP4) en connexion avec d'autres éléments de syntaxe tels que, par exemple, (CBP) ou mode macrobloc.

**6.** Procédé selon l'une des revendications précédentes, **caractérisé par le fait que**
par la transmission d'un symbole d'un seul bit (SIG) pour chaque coefficient d'u bloc et d'un symbole d'un seul bit (LAST) pour chaque coefficient de transformation différent de zéro d'un bloc est codée la reproduction de signification, la transmission ayant lieu dans l'ordre de balayage, (SIG) servant à la caractérisation des coefficients de transformation différents de zéro et (LAST) indiquant si d'autres coefficients de transformation différents de zéro sont présents dans le bloc.

7. Procédé selon la revendication 5, **caractérisé par le fait que**
le modelage

- pour le symbole d'un seul bit (CBP4),
- pour le codage de la Reproduction de signification et/ou
- pour le codage des valeurs de coefficient

a lieu en fonction du contexte.

8. Procédé selon l'une des revendications précédentes 6 ou 7, **caractérisé par le fait que**
pour la dernière position de balayage d'un bloc, il n'est pas transmis d'information de signification (SIG, LAST).

9. Procédé selon l'une des revendications précédentes, **caractérisé par le fait que**
les types de bloc de coefficients de transformation à statistiques comparables sont regroupés en catégories de bloc.

10. Aménagement avec au moins un processeur et/ou puce organisé de sorte que puisse être mis en oeuvre un procédé pour le codage de coefficients de transformation dans des codeurs et décodeurs d'images et/ou vidéo, pour les blocs d'images (vidéo) contenant des coefficients de transformation différents de zéro ayant lieu un codage des coefficients de transformation de sorte que pour chaque bloc

- soit codée une reproduction de signification qui spécifie les positions des coefficients de transformation différents de zéro dans le bloc dans l'ordre de balayage, et ensuite
- dans l'ordre de balayage inverse, en commençant par le dernier coefficient de transformation différent de zéro dans le bloc, soient codées les valeurs (levels) des coefficients de transformation différents de zéro.

11. Programme d'ordinateur permettant à un ordinateur, après qu'il ait été chargé dans la mémoire de l'ordinateur, d'exécuter un procédé pour le codage de coefficients de transformation dans des codeurs et décodeurs d'images et/ou vidéo, pour les blocs d'images (vidéo) contenant des coefficients de transformation différents de zéro ayant lieu un codage des coefficients de transformation de sorte que pour chaque bloc

- soit codée une reproduction de signification qui spécifie les positions des coefficients de transformation différents de zéro dans le bloc dans l'ordre de balayage, et ensuite
- dans l'ordre de balayage inverse, en commençant par le dernier coefficient de transformation différent de zéro dans le bloc, soient codées les valeurs (levels) des coefficients de transformation différents de zéro.

12. Support de mémoire pouvant être lu dans un ordinateur, sur lequel est mémorisé un programme permettant à un ordinateur, après qu'il ait été chargé dans la mémoire de l'ordinateur, d'exécuter un procédé pour le codage de coefficients de transformation dans des codeurs et décodeurs d'images et/ou vidéo, pour les blocs d'images (vidéo) contenant des coefficients de transformation différents de zéro ayant lieu un codage des coefficients de transformation de sorte que pour chaque bloc

- soit codée une reproduction de signification qui spécifie les positions des coefficients de transformation différents de zéro dans le bloc dans l'ordre de balayage, et ensuite
- dans l'ordre de balayage inverse, en commençant par le dernier coefficient de transformation différent de zéro dans le bloc, soient codées les valeurs (levels) des coefficients de transformation différents de zéro.

13. Flux de données représentant un programme d'ordinateur permettant à un ordinateur, après qu'il ait été chargé dans la mémoire de l'ordinateur, d'exécuter un procédé pour le codage de coefficients de transformation dans des codeurs et décodeurs d'images et/ou vidéo, pour les blocs d'images (vidéo) contenant des coefficients de transformation différents de zéro ayant lieu un codage des coefficients de transformation de sorte que pour chaque bloc

- soit codée une reproduction de signification qui spécifie les positions des coefficients de transformation différents de zéro dans le bloc dans l'ordre de balayage, et ensuite
- dans l'ordre de balayage inverse, en commençant par le dernier coefficient de transformation différent de zéro dans le bloc, soient codées les valeurs (levels) des coefficients de transformation différents de zéro.

14. Procédé pour le décodage d'un codage d'une reproduction de signification et le codage successif de valeurs de coefficients de transformations différents de zéro pour les blocs d'images (vidéo) contenant des coefficients de transformation différents de zéro, la reproduction de signification spécifiant les positions des coefficients de transformation différents de zéro dans l'ordre de balayage, et le codage des valeurs des coefficients de transformation différents de zéro présentant des valeurs codées des coefficients de transformation différents de zéro dans l'ordre de balayage inverse, en commençant par le dernier coefficient de transformation différent de zéro, avec l'étape suivante consistant à :

décoder la reproduction de signification ; et
décoder les valeurs codées des coefficients de transformation différents de zéro dans l'ordre de balayage inverse.

15. Dispositif pour le décodage d'un codage d'une reproduction de signification et d'un codage successif des valeurs des coefficients de transformation différents de zéro pour les blocs d'images (vidéo) contenant des coefficients de transformation différents de zéro, la reproduction de signification spécifiant les positions des coefficients de transformation différents de zéro dans l'ordre de balayage, et le codage des valeurs des coefficients de transformation différents de zéro présentant des valeurs codées des coefficients de transformation différents de zéro dans l'ordre de balayage inverse, en commençant par le dernier coefficient de transformation différent de zéro, avec le dispositif suivant :

un dispositif destiné à décoder la reproduction de signification ; et
un dispositif destiné à décoder les valeurs codées des coefficients de transformation différents de zéro dans l'ordre de balayage inverse.

CBP4

if (CBP)

**Signifikanz-Abbildung**

```
for (i=0; i<max_koeff[type]-1; i++)
{
        Kodiere Signifikanz-Bit (SIG[i])

        if (SIG[i])
        {
            Kodiere Block-Ende bit (LAST[i])
            if(LAST[i])
            {
                break
            }
        }
}
```

**Level-Information**

```
for (i=max_koeff[type]-1; i>=0; i--)
{
    if (SIG[i])
    {
        Kodiere ABS[i]
        Kodiere SIGN[i]
    }
}
```

## Figur 1

| Koeffizienten | 14 | 0 | -5 | 3 | 0 | 0 | -1 | 0 | 1 | 0 | 0 | 0 | 0 | 0 | 0 | 0 |
|---|---|---|---|---|---|---|---|---|---|---|---|---|---|---|---|---|
| SIG | 1 | 0 | 1 | 1 | 0 | 0 | 1 | 0 | 1 | | | | | | | |
| LAST | 0 | | 0 | 0 | | | 0 | | 1 | | | | | | | |

| Koeffizienten | 18 | -2 | 0 | 0 | 0 | -5 | 1 | -1 | 0 | 0 | 0 | 0 | 1 | 0 | 0 | 1 |
|---|---|---|---|---|---|---|---|---|---|---|---|---|---|---|---|---|
| SIG | 1 | 1 | 0 | 0 | 0 | 1 | 1 | 1 | 0 | 0 | 0 | 0 | 1 | 0 | 0 | |
| LAST | 0 | 0 | | | | 0 | 0 | 0 | | | | | 0 | | | |

## Figur 2

| ABS | Binarisierung | | | | | |
| --- | Unärer Teil | | | | Exp-Golomb-Teil | |
| 1 | | | | | | |
| 2 | | | | | | |
| 3 | | | | | | |
| 4 | | | | | | |
| 5 | | | | | | |
| 6 | | | | | | |
| 7 | | | | | | |
| 8 | | | | | | |
| 9 | | | | | | |
| 10 | | | | | | |
| 11 | | | | | | |
| 12 | | | | | | |
| 13 | | | | | | |
| 14 | | | | | | |
| 15 | | 0 | | | | |
| 16 | | 1 0 0 | | | | |
| 17 | | 1 0 1 | | | | |
| 18 | | 1 1 0 0 0 | | | | |
| 19 | | 1 1 0 0 1 | | | | |
| 20 | | 1 1 0 1 0 | | | | |
| 21 | | 1 1 0 1 1 | | | | |
| ... | | ... ... ... ... ... ... | | | | |
| bin | 1 2 3 4 5 6 7 8 9 10 11 12 13 14 | 15 16 17 18 19 ... | | | | |

## Figur 3

| Block-Typen | Koeffizienten-Anzahl | Kategorie |
| --- | --- | --- |
| DC-Luminanz-Block (INTRA 16x16-Mode) | 16 | 0: Luma-Intra16-DC |
| AC-Luminanz-Block (INTRA 16x16-Mode) | 15 | 1: Luma-Intra16-AC |
| Luminanz-Block (INTRA 4x4-Mode) | 16 | 2: Luma-4x4 |
| Luminanz-Block (INTER-Mode) | 16 | 2: Luma-4x4 |
| DC-Chrominanz-U-Block (INTRA-Mode) | 4 | 3: Chroma-DC |
| DC-Chrominanz-V-Block (INTRA-Mode) | 4 | 3: Chroma-DC |
| DC-Chrominanz-U-Block (INTER-Mode) | 4 | 3: Chroma-DC |
| DC-Chrominanz-V-Block (INTER-Mode) | 4 | 3: Chroma-DC |
| AC-Chrominanz-U-Block (INTRA-Mode) | 15 | 4: Chroma-AC |
| AC-Chrominanz-V-Block (INTRA-Mode) | 15 | 4: Chroma-AC |
| AC-Chrominanz-U-Block (INTER-Mode) | 15 | 4: Chroma-AC |
| AC-Chrominanz-V-Block (INTER-Mode) | 15 | 4: Chroma-AC |

## Figur 4

## Figur 5

| Koeffizienten | 14 | 0 | 5 | 3 | 0 | 0 | 1 | 0 | 1 | |
|---|---|---|---|---|---|---|---|---|---|---|
| ctx_number_abs_1bin | 4 | | 4 | 2 | | | 1 | | 0 | |
| ctx_number_abs_rbins | 2 | | 1 | 0 | | | | | | |

← Umgekehrte Scan-Richtung

| Koeffizienten | 18 | 2 | 1 | 6 | 4 | 5 | 1 | 1 | 0 | 1 | 0 | 0 | 1 | 0 | 0 | 1 |
|---|---|---|---|---|---|---|---|---|---|---|---|---|---|---|---|---|
| ctx_number_abs_1bin | 4 | 4 | 4 | 4 | 4 | 3 | 3 | 3 | | 2 | | | 1 | | | 0 |
| ctx_number_abs_rbins | 4 | 3 | | 2 | 1 | 0 | | | | | | | | | | |

## Figur 6